# EUROPEAN PATENT APPLICATION

(11) **EP 4 765 194 A1**
(43) Date of publication of application: **24.06.2026**
(21) Application number: 24865273.7
(22) Date of filing: 30.08.2024
(51) Int. Cl.: H01L 21/66, C30B 29/36, H01L 21/02

(54) **METHOD FOR ESTIMATING APPROPRIATE PROCESS AMOUNT**

(30) Priority: 14.09.2023 JP 2023149658
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1330 (JP); TODA, Kohei, Sanda-shi, Hyogo 669-1330 (JP); DOJIMA, Daichi, Sanda-shi, Hyogo 669-1330 (JP)
(74) Representative: Schön, Christoph
(86) International application number: PCT/JP2024/031152
(87) International publication number: WO 2025/057771

(57) **Abstract**

Provided is a technique for estimating, on the basis of the intensity of scattered light scattered on a semiconductor substrate, an appropriate amount of process to be performed on the semiconductor substrate in order to obtain a semiconductor substrate satisfying a prescribed reference. The present invention comprises: a measurement step S20 for causing laser light to be incident on a target substrate, and acquiring an intensity measurement value of scattered light scattered on the target substrate; and an estimation step S70 for, using an estimation model created on the basis of a data.

## Description

### Technical Field

The present invention relates to a technology for estimating an appropriate amount of processing when a semiconductor substrate is processed.

### Background Art

There is a known technology for evaluating a state of a surface layer of a semiconductor substrate without destroying the semiconductor substrate.

Patent Literature 1 discloses a method by which laser light is made to enter a semiconductor substrate from a surface, and a surface layer (subsurface damaged layer) including scratches and strain of the semiconductor substrate is evaluated on the basis of the intensity of scattered light scattered in the semiconductor substrate.

### Citation List

### Patent Literature

Patent Literature 1: WO 2022/158394 A

### Summary of Invention

### Technical Problem

By the above conventional technology, it is possible to evaluate a state of a surface layer without destroying the semiconductor substrate.

A semiconductor substrate formed with a compound semiconductor material such as silicon carbide is normally formed by slicing an ingot of a semiconductor material, and grinding and polishing the surface thereof. This mechanical processing such as slicing, grinding, and polishing causes scratches and crystal strain in the surface layer of the semiconductor substrate.

In the present specification, the term "strain" refers to a deviation of an actual crystal lattice from a reference in a case where an ideal crystal lattice is set as the reference. Also, an amount of strain is a value indicating the degree of the deviation.

The scratches and crystal strain cause a decrease in device yield in a device manufacturing step such as the epitaxial growth to be conducted after the mechanical processing.

Also, it is difficult to perform mechanical processing on a compound semiconductor material such as silicon carbide due to its hard and brittle physical properties, and the quality (in particular, the degree of strain, the distribution of strain, and the like) of the surface layer varies depending on the processing method and the processing conditions.

Therefore, even in a case where attention is paid to a specific process in manufacturing of actual semiconductor devices, the semiconductor substrates to be subjected to the process do not usually have constant quality. In other words, to achieve a certain predetermined quality condition, further necessary amounts of processing are present depending on the qualities of the respective semiconductor substrates.

The present invention has been made in view of the above circumstances, and aims to provide a technology for estimating an appropriate amount of processing to be performed on a semiconductor substrate on the basis of the intensity of scattered light scattered in the semiconductor substrate, to obtain a semiconductor substrate that satisfies a predetermined criterion.

### Solution to Problem

[1] A method for estimating an appropriate amount of processing to be performed on a semiconductor substrate, the method including:
   a measurement step of acquiring a measured value of an intensity of scattered light scattered in a target substrate by causing laser light to enter the target substrate; and
   an estimation step of estimating an amount of processing necessary for a reference index in the target substrate to satisfy a predetermined criterion, from the measured value of the intensity of the scattered light in the target substrate, the measured value having been obtained in the measurement step, using an estimation model created on the basis of a data set in which a measured value of an intensity of scattered light scattered in a reference substrate measured by causing laser light to enter the reference substrate is associated with an amount of processing necessary for the reference index in the reference substrate to satisfy the predetermined criterion.
[2] The estimation method according to [1], in which the amount of processing includes an amount of non-contact processing.
[3] The estimation method according to [2], in which the amount of processing includes an amount of etching.
[4] The estimation method according to any one of [1] to [3], in which the reference index includes an index measurable in a layer formed by performing an irreversible process on the reference substrate or the target substrate.
[5] The estimation method according to any one of [1] to [4], in which the reference index includes an index measurable in a layer formed by performing an irreversible process on the reference substrate or the target substrate after non-contact processing.
[6] The estimation method according to any one of [1] to [5], in which the reference index includes an index measurable in an epitaxial growth layer formed by epitaxially growing the reference substrate or the target substrate.
[7] The estimation method according to any one of [1] to [6], in which the reference index includes an index measurable in an epitaxial growth layer formed by epitaxially growing the reference substrate or the target substrate after etching.
[8] The estimation method according to any one of [1] to [7], in which the reference index includes a killer defect density in an epitaxial growth layer formed by epitaxially growing the reference substrate or the target substrate.
[9] The estimation method according to any one of [1] to [8], in which the reference index includes an in-grown stacking fault (IGSF) density in an epitaxial growth layer formed by epitaxially growing the reference substrate or the target substrate.
[10] The estimation method according to any one of [1] to [9], in which the reference index includes a basal plane dislocation (BPD) density in an epitaxial growth layer formed by epitaxially growing the reference substrate or the target substrate.
[11] The estimation method according to any one of [1] to [10], in which the reference index includes a basal plane dislocation (BPD) propagation rate in an epitaxial growth layer formed by epitaxially growing the reference substrate or the target substrate.
[12] The estimation method according to any one of [1] to [11], further including a planarization step of planarizing a surface of the target substrate before the measurement step.
[13] The estimation method according to any one of [1] to [12], in which the target substrate has an arithmetic average roughness Ra of less than 0.8 nm on a surface.
[14] The estimation method according to any one of [1] to [13], in which the laser light is polarized light.
[15] The estimation method according to [14], in which the laser light is P-polarized light or S-polarized light.
[16] A method for manufacturing a semiconductor substrate, including a step of performing processing on the target substrate, on the basis of the appropriate amount of processing to be performed on the target substrate, the appropriate amount of processing having been estimated by the estimation method according to any one of [1] to [15].
[17] A method for creating an estimation model, including:
   a first measurement step of acquiring a measured value of an intensity of scattered light scattered in each reference substrate of a plurality of reference substrates measured by causing laser light to enter each of the reference substrates;
   a processing step of performing a process including processing of a different process amount on each of the reference substrates;
   a second measurement step of measuring a reference index of each of the reference substrates;
   an analysis step of creating a first data set in which the reference index of each of the reference substrates is associated with the amount of processing performed on each of the reference substrates, and estimating an amount of processing necessary for the reference index of each of the reference substrates to satisfy a predetermined criterion, on the basis of the first data set; and
   an estimation model creating step of creating a second data set in which the amount of processing necessary for the reference index of each of the reference substrates estimated in the analysis step to satisfy the predetermined criterion is associated with the measured value of the intensity of the scattered light measured in the first measurement step, and creating an estimation model for estimating an appropriate amount of processing to be performed on a target substrate from a measured value of an intensity of scattered light in the target substrate, on the basis of the second data set.
[18] The estimation method according to any one of [1] to [15], in which the estimation model is an estimation model created using the method for creating an estimation model according to claim 1.

By the invention according to [1], it is possible to estimate an amount of processing necessary for a reference index in a target substrate to satisfy a predetermined criterion from a measured value of intensity of scattered light in the target substrate, using an estimation model created on the basis of a data set in which a measured value of intensity of scattered light scattered in a reference substrate is associated with the amount of processing necessary for a reference index in the reference substrate to satisfy the predetermined criterion. Thus, an appropriate amount of processing to be performed on a semiconductor substrate can be estimated in a non-destructive manner and at high speed.

By the invention according to [2], in a case where a subsurface damaged layer is to be processed so as not to generate a new subsurface damaged layer, in particular, an appropriate amount of non-contact processing (etching, epitaxial growth, or the like) to be performed on the semiconductor substrate can be estimated in a non-destructive manner and at high speed.

Furthermore, non-contact processing does not introduce any new subsurface damaged layer into the substrate, and therefore, the amount of necessary non-contact processing can be a value indicating the substrate's quality.

By the invention according to [3], in a case where an appropriate amount of the subsurface damaged layer is to be removed by etching, in particular, an appropriate amount of processing to be performed on the semiconductor substrate can be estimated in a non-destructive manner and at high speed.

By the invention according to [4], for improving the quality of the layer to be formed by performing an irreversible process on a target substrate, it is possible to estimate the necessary amount of processing in a non-destructive manner and at high speed from the measured value of the intensity of scattered light scattered in the target substrate.

By the invention according to [5], for improving the quality of the layer to be formed by performing an irreversible process on a target substrate after non-contact processing, it is possible to estimate the necessary amount of non-contact processing in a non-destructive manner and at high speed from the measured value of the intensity of scattered light scattered in the target substrate.

By the invention according to [6], the present estimation method can be used along a device manufacturing step including an epitaxial growth step.

By the invention according to [7], the present estimation method can be used along a device manufacturing step including an epitaxial growth step after an etching step.

By the invention according to [8], in a case where a device is manufactured from a target substrate, it is possible to estimate an amount of processing with which a subsurface damaged layer that causes serious defects in the characteristics in a manufactured device can be processed, and thus, it is possible to increase the yield of devices to be manufactured.

By the invention according to [9], it is possible to estimate an amount of processing with which a subsurface damaged layer that generates IGSFs particularly in an epitaxial growth layer of the target substrate after epitaxial growth can be processed. Thus, the quality of the processed target substrate can be enhanced, and the yield of devices to be manufactured can be increased.

By the invention according to [10], it is possible to estimate an amount of processing with which a subsurface damaged layer that generates BPD particularly in an epitaxial growth layer of the target substrate after epitaxial growth can be processed. Thus, the quality of the processed target substrate can be enhanced, and the yield of devices to be manufactured can be increased.

By the invention according to [11], it is possible to estimate an amount of processing with which a subsurface damaged layer of the target substrate can be processed so as to reduce BPD propagation into an epitaxial growth layer of the target substrate particularly after epitaxial growth. Thus, the quality of the processed target substrate can be enhanced, and the yield of devices to be manufactured can be increased.

By the invention according to [12], in particular, the amount of laser light entering a semiconductor substrate can be increased, and an appropriate amount of processing to be performed on the semiconductor substrate can be estimated in a non-destructive manner and at high speed, from a measured value of the intensity of scattered light derived from a subsurface damaged layer in the semiconductor substrate.

By the invention according to [13], in particular, the amount of laser light entering a semiconductor substrate can be increased, and an appropriate amount of processing to be performed on the semiconductor substrate can be estimated in a non-destructive manner and at high speed, from a measured value of the intensity of scattered light derived from a subsurface damaged layer in the semiconductor substrate.

By the invention according to [14], an appropriate amount of processing to be performed on the semiconductor substrate can be estimated in a non-destructive manner and at high speed, from a measured value of the intensity of scattered light derived from a subsurface damaged layer at a specific location in the semiconductor substrate, the measured value corresponding to the polarization state of laser light.

By the invention according to [15], in particular, the amount of laser light entering a semiconductor substrate can be increased, and an appropriate amount of processing to be performed on the semiconductor substrate can be estimated in a non-destructive manner and at high speed, from a measured value of the intensity of scattered light derived from a subsurface damaged layer in the semiconductor substrate.

By the invention according to [16], the target substrate can be processed by the necessary amount of processing. Thus, it is possible to increase the yield of devices to be manufactured, while enhancing the quality of the processed target substrate.

By the invention according to [17], an estimation model to be used in the method for estimating an appropriate amount of processing to be performed on a semiconductor substrate can be created.

By the invention according to [18], it is possible to estimate an appropriate amount of processing to be performed on a semiconductor substrate, using an estimation model created on the basis of a data set in which measured values of intensity of scattered light scattered in a plurality of reference substrates are associated with the amounts of processing necessary for reference indexes in the reference substrates to satisfy a predetermined criterion.

### Advantageous Effects of Invention

The present invention is to provide a technology for estimating an appropriate amount of processing to be performed on a semiconductor substrate on the basis of the intensity of scattered light scattered in the semiconductor substrate, to obtain a semiconductor substrate that satisfies a predetermined condition.

### Brief Description of Drawings

Fig. 1 is a diagram for explaining a (first) measurement step according to an embodiment of the present invention.
Fig. 2 is a diagram for explaining a (first) measurement step according to an embodiment of the present invention.
Fig. 3 is a diagram illustrating scattered light intensities measured in a plurality of reference substrates according to an embodiment of the present invention.
Fig. 4 is a diagram illustrating examples of a first data set in which etching amounts are associated with IGSF densities for a plurality of reference substrates according to an embodiment of the present invention.
Fig. 5 is a diagram illustrating examples of a first data set in which etching amounts are associated with BPD densities for a plurality of reference substrates according to an embodiment of the present invention.
Fig. 6 is a diagram illustrating examples of a first data set in which etching amounts are associated with BPD propagation rates for a plurality of reference substrates according to an embodiment of the present invention.
Fig. 7 is a diagram illustrating amounts of etching necessary for epitaxial growth layers of reference substrates to satisfy a predetermined criterion according to an embodiment of the present invention.
Fig. 8 is a diagram illustrating examples of a second data set and an estimation model according to an embodiment of the present invention.
Fig. 9 is a diagram illustrating examples of a second data set and an estimation model according to an embodiment of the present invention.
Fig. 10 is a distribution diagram of scattered light intensity and necessary amounts of processing according to an embodiment of the present invention.
Fig. 11 is a diagram illustrating the relationship between the scattered light intensity obtained in a case where S-polarized light or P-polarized light is made to enter a substrate and the surface roughness of the substrate, according to an embodiment of the present invention.
Fig. 12 is a diagram illustrating the relationship between the scattered light intensity obtained in a case where S-polarized light or P-polarized light is made to enter a substrate and the surface roughness of the substrate, according to an embodiment of the present invention.

### Description of Embodiments

The present invention includes: a measurement step of causing laser light to enter a target substrate, and acquiring a measured value of intensity of scattered light scattered in the target substrate;
and an estimation step of estimating an amount of processing necessary for a reference index in the target substrate to satisfy a predetermined criterion from the measured value of the intensity of the scattered light in the target substrate, using an estimation model to be described later.

In the present invention, an amount of processing is preferably an amount of change in the thickness of a semiconductor substrate. More specifically, an amount of processing is an amount of decrease in thickness, which is an amount of etching, or an amount of increase in thickness, which is an amount of growth.

That is, an amount of etching can be expressed as "-3 µm", "-4 µm", or the like, and an amount of growth can be expressed as "+10 µm", "+15 µm", or the like.

Alternatively, after a processing method is defined, the absolute amount of change in thickness can be expressed as "3 µm", "4 µm", "10 µm", "15 µm", or the like.

Also, in the present invention, an amount of processing may be a condition for processing, such as a time or a temperature of certain processing.

Also, an amount of processing may be information indicating both a type of processing and the amount thereof, for example. That is, an amount of processing may be information such as "etching: -3 µm", "thermal etching: 4 µm", "epitaxial growth: +10 µm", or "sublimation method: 15 µm".

Alternatively, a process condition (process temperature, process time, or the like) during processing may also be handled as an amount of indirect processing.

In the present invention, a second data set is correlation data in which a measured value of intensity of scattered light scattered in a reference substrate measured by causing laser light to enter the reference substrate is associated with an amount of processing necessary for a reference index in the reference substrate to satisfy a predetermined criterion.

A measured value of intensity of scattered light may be expressed by numerical data such as statistical values like location parameters (including one or more values selected from among an average (arithmetic/geometric/harmonic), a median value (quantile/order statistics), a mode value, a class value, and the like, for example) and scale parameters (including one or more values selected from among a variance, a deviation value, a standard deviation, a mean deviation, a median absolute deviation, a range, a half-value width, and the like, for example) obtained by statistically processing a plurality of measured values obtained from the entire main surface of a substrate.

Also, a measured value of intensity of scattered light may be expressed by a distribution image obtained by mapping, in line with a substrate, a plurality of measured values obtained from the entire main surface of the substrate, or image data such as a histogram of the plurality of measured values.

The second data set is a data set in which a measured value of intensity of scattered light and a necessary amount of processing are associated with each other.

Therefore, in a case where a measured value of intensity of scattered light is expressed by numerical data such as the statistical values described above, for example, an estimation model for estimating the necessary amount of processing as an output value with the measured value of the intensity of scattered light as an input value can be created on the basis of regression analysis of the second data set.

Furthermore, in a case where a measured value of intensity of scattered light is expressed by the above-described distribution image of a plurality of measured values or image data such as a histogram, for example, an estimation model for estimating a necessary amount of processing as an output value with the measured value of the intensity of scattered light as an input value can be created on the basis of machine learning using the second data set as training data.

An amount of processing may be either an amount of contact processing or an amount of non-contact processing.

Contact processing is a process for processing the main surface of a substrate by bringing another member into contact with the main surface of the substrate, such as mechanical polishing (MP) or chemical mechanical polishing (CMP), and can also be referred to as mechanical processing.

Non-contact processing is a process for processing the main surface of a substrate without bringing another member into contact with the main surface of the substrate, such as etching (wet etching such as hydrogen etching, thermal etching, or Si vapor pressure etching), epitaxial growth (a chemical vapor deposition (CVD) method, a sublimation method, or the like), or annealing.

In a preferred mode of the present invention, an estimation model is created with the use of an amount of non-contact processing. By this method, it is possible to estimate how much amount of processing is appropriate in a case where non-contact processing is used.

In other words, an estimation model created with the use of an amount of non-contact processing is an estimation model not intended to newly introduce scratches and strain in the subsequent processing, and therefore, can be handled as a model for estimating the depth of the surface layer (subsurface damaged layer) that adversely affects the device and is to be removed from the target substrate.

Accordingly, in a mode using an estimation model created with the use of an amount of non-contact processing, the present invention can also be a method for estimating the depth of the surface layer (subsurface damaged layer) that adversely affects the device and is to be removed.

Of course, if an estimation model is created using an amount of specific contact processing, it is possible to estimate how much should be removed by the contact processing. Therefore, if it is known beforehand that the subsequent processing is contact processing, it is preferable to create an estimation model by this method.

Note that the amount of in-grown stacking fault (IGSF), which is a kind of killer defect, is directly affected by the depth of the surface layer (subsurface damaged layer) to be removed.

Therefore, the present invention might be capable of further estimating the amount of IGSF generated when the target substrate is epitaxially grown as it is, from the depth of the surface layer (subsurface damaged layer) to be removed from the target substrate, the depth having been estimated in the mode using an estimation model created with the use of the amount of non-contact processing.

A method for creating an estimation model according to the present invention includes: a first measurement step of acquiring a measured value of intensity of scattered light scattered in each reference substrate of a plurality of reference substrates measured by causing laser light to enter each of the reference substrates; a processing step of performing a process including processing of a different process amount on each of the reference substrates; a second measurement step of measuring a reference index of each of the reference substrates; an analysis step of creating a first data set in which the reference index of each of the reference substrates is associated with the amount of processing performed on each of the reference substrates, and estimating an amount of processing necessary for the reference index of each of the reference substrates to satisfy a predetermined criterion, on the basis of the first data set; and an estimation model creating step of creating a second data set in which the amount of processing necessary for the reference index of each of the reference substrates estimated in the analysis step to satisfy the predetermined criterion is associated with the measured value of the intensity of the scattered light, and creating an estimation model for estimating an appropriate amount of processing to be performed on a target substrate from a measured value of intensity of scattered light in the target substrate, on the basis of the second data set.

In the present invention, a plurality of reference substrates is prepared as a plurality of substrates of various qualities, and is classified into a plurality of substrate groups each including substrates of the same quality, on the basis of degrees of similarity in quality.

For example, it is assumed that substrates a1, a2, a3,... are classified in a substrate group A, and substrates b1, b2, b3,... are classified in a substrate group B.

In this case, the substrates a1, a2, a3,... have similar qualities, and the substrates b1, b2, b3,... also have similar qualities.

On the other hand, any one of the substrates a1, a2, a3,... and any one of the substrates b1, b2, b3,... have different qualities.

In an embodiment of the present invention, a plurality of reference substrates is classified into a plurality of substrate groups based on the manufacturing companies of the respective substrates and the product grades presented by these manufacturing companies.

Alternatively, a plurality of reference substrates may be classified into a plurality of substrate groups, with measured value of scattered light intensity in each of the reference substrates being used as a quality reference.

In the present invention, reference indexes include an index (killer defect density, BPD propagation rate, ion concentration, doping concentration, or the like) in a layer formed by performing an irreversible process (epitaxial growth, doping, ion implantation, subsequent annealing, oxide film formation, or the like) on a reference substrate subjected to contact processing or non-contact processing.

That is, an irreversible process is defined as a process that cannot be substantially performed again on the same substrate, because of economic efficiency, technical difficulty, or some other reason.

For example, the IGSF density in an epitaxial growth layer formed when epitaxial growth is performed on the reference substrate after etching can be used as a reference index.

In the present invention, a first data set is a data set in which the reference indexes measured in the respective reference substrates are associated with amounts of processing indicating processes performed on the respective reference substrates by different amounts.

Thus, a model for estimating a necessary amount of processing as an output value, with a desired reference index being used as an input value, can be created on the basis of regression analysis or the like for the first data set.

In the present invention, the second data set is a data set in which a measured value of intensity of scattered light scattered in a reference substrate measured by causing laser light to enter the reference substrate is associated with an amount of processing necessary for the reference substrate to have a desired reference index, the necessary amount of processing being estimated from the first data set.

Therefore, in a case where a measured value of intensity of scattered light is expressed by numerical data such as the statistical values described above, for example, an estimation model for estimating the necessary amount of processing as an output value with the measured value of the intensity of scattered light as an input value can be created on the basis of regression analysis of the second data set.

Furthermore, in a case where a measured value of intensity of scattered light is expressed by the above-described distribution image of a plurality of measured values or image data such as a histogram, for example, an estimation model for estimating a necessary amount of processing as an output value with the measured value of the intensity of scattered light as an input value can be created on the basis of machine learning with respect to the second data set.

In the description below, preferred embodiments of a method for estimating an appropriate amount of processing to be performed on a semiconductor substrate (hereinafter referred to as a method for estimating an amount of processing), a method for manufacturing a semiconductor substrate, and a method for creating an estimation model, according to the present invention, will be described in detail with reference to the accompanying drawings. The technical scope of the present invention is not limited by the embodiments illustrated in the accompanying drawings, but can be changed as appropriate within the scope disclosed in the claims. Note that, in the following description of embodiments and the accompanying drawings, the same components are denoted by the same reference numerals, and repetitive explanation will be avoided.

### <<Method for Creating Estimation Model>>

In the following, a method for creating an estimation model implemented using a plurality of reference substrates including substrate groups A to F is described.

Note that, in the present embodiment, the plurality of reference substrates is classified into the substrate groups A to F based on the manufacturing companies of the respective substrates and the product grades presented by these companies.

### <Cleaning/Planarization Step S10>

A method for creating an estimation model according to the present invention can include a cleaning/planarization step S10 that includes a cleaning step S11 and a planarization step S12, depending on the surface state of a semiconductor substrate 100 (a reference substrate).

The cleaning step S11 is a step of eliminating factors of scattering of laser light L1 on a surface 101 of the semiconductor substrate 100 due to organic contamination, particle contamination, an oxide layer, ion contamination, or the like adhering to the surface of the semiconductor substrate 100. In particular, in a case where particles adhere to the surface of the semiconductor substrate 100, there occurs stronger scattering than scattering of scattered light L4 generated in a subsurface damaged layer 102, which leads to degradation of the correlation between the scattered light intensity and the amount of processing. Therefore, it is desirable that particle contamination and the like are removed before measurement of the intensity of scattered light.

The cleaning step S11 has an effect of reducing generation of scattered light derived from surface-adhering matter, or lowering the intensity of scattered light derived from surface-adhering matter. Thus, in the scattered light L4, the ratio of scattered light derived from surface-adhering matter can be reduced, and the correlation between the measured value of scattered light intensity and the amount of processing can be improved.

As the technique in the cleaning step S11, it is possible to adopt any technique by which at least one of organic contamination, particle contamination, an oxide layer, and ion contamination adhering to the surface 101 of the semiconductor substrate 100 can be removed. For example, chemical cleaning such as general RCA cleaning (NH₄OH, H₂O₂, H₂O) or acid cleaning (HCl, HF), or physical cleaning with bubbles, a brush, or the like can be adopted. Other than that, it is of course possible to adopt any technique by which the surface 101 of the semiconductor substrate 100 can be cleaned.

The planarization step S12 is a step of eliminating the factor of the laser light L1 being scattered on the surface 101 of the semiconductor substrate 100 due to surface irregularities or the like of the semiconductor substrate 100. In particular, in a case where the surface of the semiconductor substrate 100 is rough, there occurs stronger scattering than scattering of the scattered light L4 generated in the subsurface damaged layer 102, which leads to degradation of the correlation between the scattered light intensity and the amount of processing. Therefore, it is desirable that the surface irregularities are sufficiently planarized before measurement of scattered light intensity.

The planarization step S12 has an effect of reducing generation of scattered light derived from surface irregularities, or lowering the intensity of scattered light derived from surface irregularities. Thus, in the scattered light L4, the ratio of scattered light derived from surface irregularities can be reduced, and the correlation between the measured value of scattered light intensity and the amount of processing can be improved.

As the technique in the planarization step S12, it is possible to adopt any technique by which irregularities on the surface 101 of the semiconductor substrate 100 can be planarized. For example, a mechanical processing method such as chemical mechanical polishing, various kinds of etching, and the like can be adopted. Other than that, it is of course possible to adopt any technique by which irregularities on the surface 101 of the semiconductor substrate 100 can be planarized.

The cleaning step S11 and the planarization step S12 according to the embodiment have been described so far. Note that an example of the method for creating an estimation model according to the present invention can be a mode not including the cleaning step S11 and/or the planarization step S12. That is, in a case where the surface 101 of the semiconductor substrate 100 is sufficiently clean or is sufficiently flat, the cleaning step S11 and/or the planarization step S12 is not necessarily performed, and the process may move on to the subsequent first measurement step S20.

### <First Measurement Step S20>

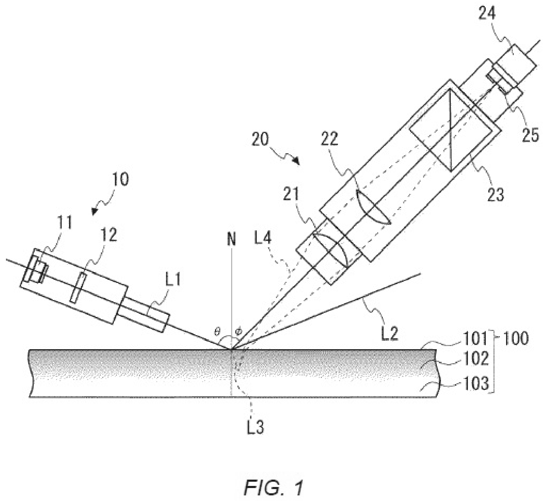

Fig. 1 is a diagram illustrating a first measurement step S20 to be performed in the method for creating an estimation model according to the embodiment of the present invention.

In the first measurement step S20, a measured value of the intensity of scattered light L4 scattered in the subsurface damaged layer 102 present on or below the front surface 101 of the semiconductor substrate 100 (reference substrate) is obtained. Specifically, the laser light L1 emitted from a light projecting system 10 enters from the surface 101 of the semiconductor substrate 100. As incident light L3 that has entered the semiconductor substrate 100 is scattered in the subsurface damaged layer 102, the scattered light L4 is generated. A light receiving system 20 receives and measures this scattered light L4, to obtain a measured value of the intensity of the scattered light L4.

For example, the light projecting system 10 to be used in the first measurement step S20 includes a laser output unit 11 and a wave plate 12. The light projecting system 10 is attached in such a manner that the laser light L1 enters at an incident angle θ inclined with respect to the normal line N of the surface of the semiconductor substrate 100.

Note that the light projecting system 10 may be attached so that the incident angle θ can be adjusted.

The laser output unit 11 is a generation source of the laser light L1, and a gas laser such as a He-Ne laser, a semiconductor laser, a solid-state laser such as a YAG laser, or the like can be adopted, for example.

The wave plate 12 performs adjustment, such as wavelength separation, fine adjustment, ellipticity adjustment, and polarization rotation, on the laser light L1 generated by the laser output unit 11. The wave plate 12 can switch the laser light L1 between S-polarized light and P-polarized light, and can control the penetration characteristics of the laser light L1 without changing the measurement conditions such as the incident angle θ and wavelength A. The appropriate material and configuration for the wave plate 12 are selected depending on the material and condition of the semiconductor substrate 100 to be measured.

The light receiving system 20 to be used in the first measurement step S20 includes an objective lens 21, an imaging lens 22, a beam splitter 23, a light receiving sensor 24, and a slit 25, for example. This light receiving system 20 is desirably attached at a measurement angle φ different from the incident angle θ so that reflected light L2 does not enter.

The light receiving system 20 may be attached so that the measurement angle φ can be adjusted.

As the beam splitter 23, it is desirable to adopt a cube beam splitter. As for the light receiving sensor 24, a photomultiplier tube, a photodiode, or the like can be adopted as a configuration capable of converting the intensity of the scattered light L4 into an electric signal. The slit 25 is provided to determine the inspection range of the laser light L1.

By the method for creating an estimation model according to the embodiment of the present invention, a measured value of the intensity of the scattered light L4 is obtained for each of the reference substrates, using the above-described measurement system (the light projecting system and the light receiving system) (first measurement step S20).

The scattered light L4 may include surface scattered light and internal scattered light. The surface scattered light may include scattered light derived from surface-adhering matter, scattered light derived from surface irregularities, and scattered light derived from crystal defects. The internal scattered light may include scattered light derived from crystal defects/strain.

The semiconductor substrate 100 is a semiconductor material manufactured by a process including at least one of a slicing step, a polishing step, and a grinding step. An example of the semiconductor substrate 100 manufactured through these steps may be a silicon (Si) substrate. In the slicing step, the polishing step, and the grinding step mentioned above, the subsurface damaged layer 102 that adversely affects device manufacturing can be introduced. In particular, as for a compound semiconductor material classified as a material that is difficult to process, recent studies have revealed that the subsurface damaged layer 102 adversely affects a device.

A method for estimating an amount of processing, a method for manufacturing a semiconductor substrate, and a method for creating an estimation model according to the present invention are suitably used in compound semiconductor material substrates such as a silicon carbide (SiC) substrate, a gallium nitride (GaN) substrate, an aluminum nitride (AlN) substrate, a gallium oxide (Ga₂O₃) substrate, and a sapphire substrate.

The semiconductor substrate 100 includes the surface 101 planarized by chemical mechanical polishing or the like, the subsurface damaged layer 102 introduced by a process including mechanical processing such as a slicing step, a grinding step, and a polishing step, and a bulk layer 103. The subsurface damaged layer 102 and the bulk layer 103 do not have a clear boundary between the layers, and it is considered that the subsurface damaged layer 102 in which the degree of strain is lower at an inner portion is continuously distributed in a state where the boundary with the bulk layer 103 is unclear.

In other words, it can be said that the subsurface damaged layer 102 is a concept referring to a layer having a relatively large amount of strain (to an extent that affects device manufacturing), the bulk layer 103 is a concept referring to a layer having a relatively small or negligible amount of strain, and there is no clear boundary separating the two layers.

The surface 101 is preferably planarized by a planarization process such as chemical mechanical polishing (CMP). Note that a preferred degree of planarity of the surface 101 will be described later.

The laser light L1 enters the inside from the surface 101 of the semiconductor substrate 100. That is, the surface 101 is the boundary surface on which the laser light L1 is incident.

Accordingly, as the semiconductor substrate 100 has the surface 101 planarized by a planarization process, scattered light due to irregularities (roughness) of the surface 101 is less likely to be generated, or the intensity of scattered light generated on the surface 101 is relatively low. In other words, the planarized surface 101 has an effect of reducing generation of scattered light derived from surface irregularities, or lowering the intensity of scattered light derived from surface irregularities.

Because of this, in the scattered light L4, the ratio of the scattered light generated in the subsurface damaged layer 102 below the surface 101 is higher, and the measured value of the intensity of scattered light and the amount of processing exhibit a good correlation.

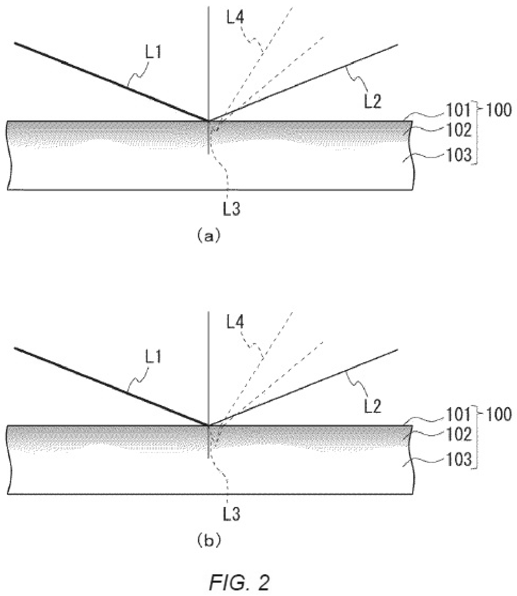

Fig. 2 is an explanatory diagram for explaining the relationship between polarization of the laser light L1 and the subsurface damaged layer 102 in the first measurement step S20. Fig. 2(a) is an explanatory diagram for explaining a case where the semiconductor substrate 100 is irradiated with S-polarized laser light L1. Fig. 2(b) is an explanatory diagram illustrating a case where the semiconductor substrate 100 is irradiated with P-polarized laser light L1.

The first measurement step S20 may include a measurement step S21 using S-polarized light, in which S-polarized laser light L1 is made to enter from the surface 101 of the semiconductor substrate 100 including the subsurface damaged layer 102, and the intensity of the scattered light L4 scattered below the surface 101 is measured (see Fig. 2(a)). Note that, as for S-polarized light, the electric field of the laser light L1 vibrates in a direction perpendicular to the incident surface, and the transmittance is lower than that of P-polarized light irradiated under the same conditions. Therefore, with the total amount, the energy, and the like of the incident light L3 being taken into consideration, scattered light of S-polarized light generated in a relatively shallow portion is detected more easily compared with P-polarized light, and S-polarized light is suitable for measurement in a shallow portion of the subsurface damaged layer 102.

Specifically, S-polarized light is suitable for measurement in a depth range from the substrate surface to 10 µm, to 8 µm, to 6 µm, or to 4 µm.

That is, in the measurement step S21 using S-polarized light, the S-polarized laser light L1 is made to enter from the surface 101 of the semiconductor substrate 100 including the subsurface damaged layer 102, and it is possible to obtain a measured value of the intensity of the scattered light L4 generated mainly in a depth range of about 10 µm below the surface 101.

The first measurement step S20 may also include a measurement step S22 using P-polarized light, in which the P-polarized laser light L1 is made to enter from the surface 101 of the semiconductor substrate 100, and the intensity of the scattered light L4 scattered below the surface 101 is measured (see Fig. 2(b)). Note that, as for P-polarized light, the electric field of the laser light L1 vibrates in a direction parallel to the incident surface, and the transmittance is higher than that of S-polarized light irradiated under the same conditions. Therefore, with the total amount, the energy, and the like of the incident light L3 being taken into consideration, scattered light of P-polarized light generated in a relatively deep portion is detected more easily compared with S-polarized light, and P-polarized light is suitable for measurement in a deep portion of the subsurface damaged layer 102.

Specifically, P-polarized light is suitable for measurement in a range from the substrate surface to 47 µm, to 30 µm, to 20 µm, or to 10 µm.

That is, in the measurement step S22 using P-polarized light, the P-polarized laser light L1 is made to enter from the surface 101 of the semiconductor substrate 100 including the subsurface damaged layer 102, and it is possible to obtain a measured value of the intensity of the scattered light L4 generated in a depth range of about 47 µm below the surface 101.

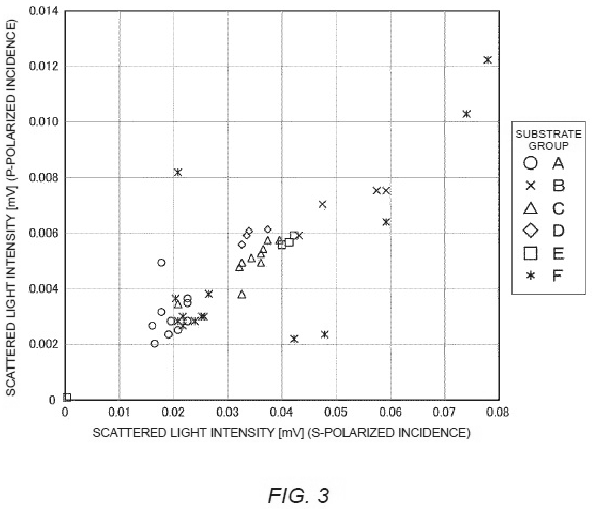

In the embodiment of the present invention, a measured value of the intensity of scattered light (scattered light intensity) in a case where P-polarized light and/or the S-polarized light is made to enter each reference substrate of the substrate groups A to F is obtained (Fig. 3) through the first measurement step S20 as described above. In the present embodiment, the plurality of reference substrates is classified into the substrate groups A to F based on the manufacturing companies of the substrates and the product grades presented by the manufacturing companies. However, the substrates can be reclassified into the substrate groups A to F based on the scattered light intensities obtained when P-polarized light and/or S-polarized light is made to enter the substrates, for example.

### <Processing Step S30>

A processing step S30 includes: a first processing step S31 in which the plurality of reference substrates having the same quality, for which the measured values of scattered light have been obtained in the first measurement step S20, are subjected to processing with different amounts of processing for the respective substrates; and a second processing step S32 in which an irreversible process (epitaxial growth, doping, ion implantation, subsequent annealing, oxide film formation, and the like) of the same amount of processing is performed on each substrate.

In the first processing step S31 according to the embodiment of the present invention, different amounts of etching are performed on the respective reference substrates.

In the second processing step S32 according to the embodiment of the present invention, epitaxial growth is performed under the same conditions, and the same amount of epitaxial growth is performed on each of the reference substrates subjected to different amounts of etching in the first processing step S31.

### <Second Measurement Step S40>

A second measurement step S40 is a step of measuring a reference index for each of the reference substrates.

In the second measurement step S40 according to the embodiment of the present invention, in the processing step S30, the killer defect density (including IGSF density, BPD density, and the like), the BPD propagation rate, the BPD conversion rate, or the like in the epitaxial growth layer is measured as a reference index for each of the reference substrates that have undergone different amounts of etching for the respective substrates and the same amount of epitaxial growth for each substrate.

Note that killer defects are known as a generic term for defects that cause serious defects in the characteristics of a semiconductor device to be produced from a substrate, among defects present in the substrate.

### <Analysis Step S50>

An analysis step S50 includes: a step S51 of creating a first data set in which the reference index measured in the second measurement step S40 and the amount of processing performed in the first processing step S31 are associated with each other for each of the reference substrates; and a step S52 of estimating a processing amount necessary for the reference index of each reference substrate to satisfy a predetermined criterion, on the basis of the first data set.

In step S51 according to the embodiment of the present invention, a first data set in which the killer defect density (including IGSF density and BPD density) in the epitaxial growth layer is associated with the amount of processing performed in the processing step S30 is created for each of the reference substrates that have undergone the second measurement step S40.

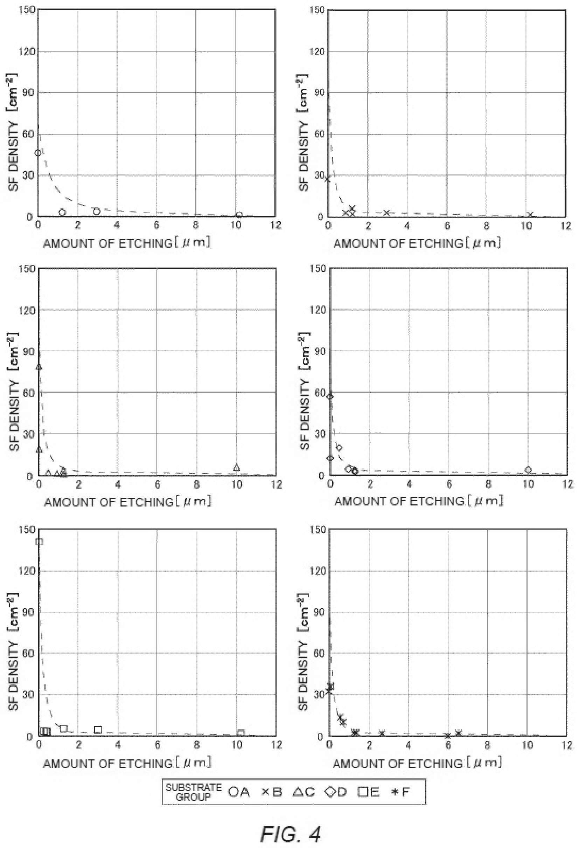

For example, as illustrated in Fig. 4, it is possible to create a first data set in which the amount of etching performed in the first processing step S31 and the SF density are associated with each other.

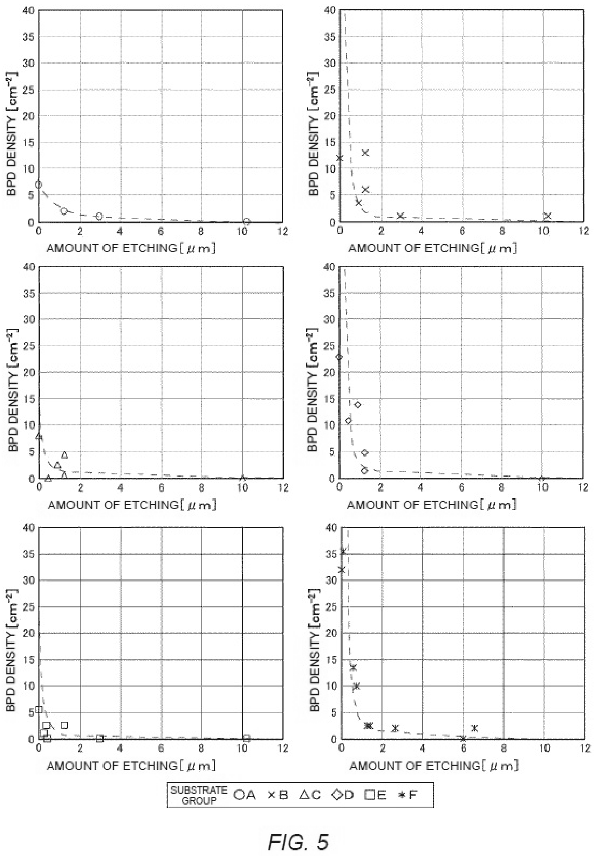

Alternatively, as illustrated in Fig. 5, it is possible to create a first data set in which the amount of etching performed in the first processing step S31 and the BPD density are associated with each other.

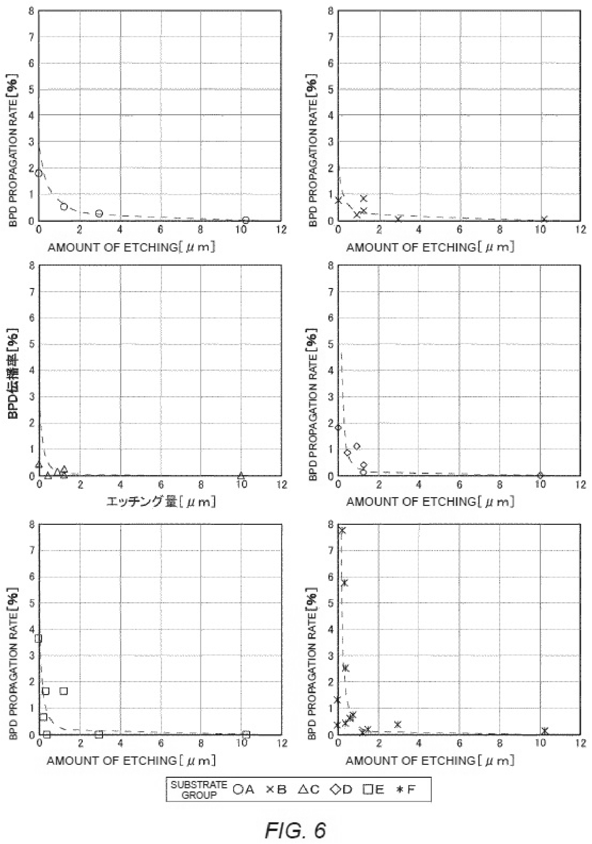

Also, as illustrated in Fig. 6, it is possible to create a first data set in which the amount of etching performed in the first processing step S31 and the BPD propagation rate are associated with each other.

In step S52, an amount of processing necessary for the reference index of each reference substrate to satisfy a predetermined criterion is estimated. The predetermined criterion according to the present embodiment is set as follows: the SF density (reference index) in the epitaxial growth layer is equal to or lower than a predetermined value (0.5 cm⁻² in the present embodiment), and the BPD propagation rate (reference index) in the epitaxial growth layer is equal to or lower than a predetermined value (0.1% in the present embodiment).

Note that the above predetermined criterion is merely an example. The predetermined criterion can be freely determined according to the desired substrate quality, including the reference index and the predetermined value at which the reference index aims. For example, the SF density (reference index) being 0.1 cm⁻² or lower in the epitaxial growth layer may be set as the predetermined criterion.

In step S52 according to the embodiment of the present invention, the amount of processing necessary for the reference index of each reference substrate to satisfy the predetermined criterion is estimated from the exponential relationship between the killer defect density (IGSF density, BPD density) or the BPD propagation rate, and the etching amount, which are illustrated in Figs. 4 to 6.

In the case of the present embodiment, in Figs. 4 to 6, the killer defect density (IGSF density, BPD density) and the BPD propagation rate decrease exponentially with respect to the amount of etching performed in the first processing step S31.

Thus, the amount of processing necessary for the reference index of each reference substrate to satisfy the predetermined criterion can be estimated from an approximate curve indicated by a dashed line in each graph or an approximate expression indicating the approximate curve.

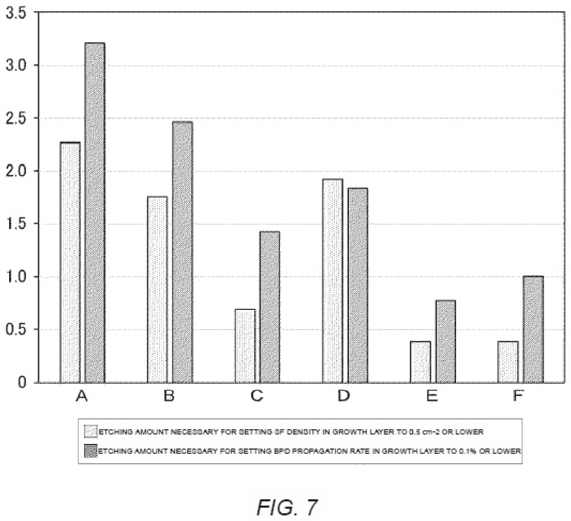

Through the analysis step S50 according to the embodiment of the present invention, the amount of etching necessary for setting the SF density in the epitaxial growth layer to 0.5 cm⁻² or lower, and the amount of etching necessary for setting the BPD propagation rate in the epitaxial growth layer to 0.1% or lower are estimated for each of the reference substrates in the substrate groups A to F (Fig. 7).

Note that, in a similar manner, it is also possible to estimate the amount of etching necessary for setting the BPD density or some other killer defect density in the epitaxial growth layer of each reference substrate in the substrate groups A to F to a predetermined value or lower.

### <Estimation Model Creating Step S60>

An estimation model creating step S60 includes: a step S61 of creating a second data set in which the amount of processing necessary for the reference index of each reference substrate to satisfy the predetermined criterion as estimated in the analysis step S50 is associated with the measured value of the scattered light intensity in each reference substrate as obtained in the first measurement step S20; and a step S62 of creating an estimation model for estimating the necessary amount of processing from the measured value of the scattered light intensity, on the basis of the second data set.

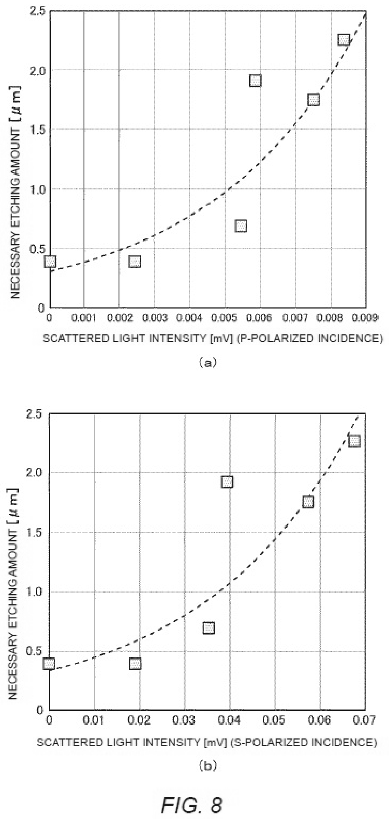

In step S61 according to the embodiment of the present invention, as illustrated in Fig. 8, a second data set is created in which the amount of etching necessary for setting the IGSF density in the epitaxial growth layer of each reference substrate to 0.5 cm⁻² or lower is associated with the measured value of the scattered light intensity obtained in a case where P-polarized light and S-polarized light are made to enter each reference substrate.

Further, in step S62 according to the embodiment of the present invention, an estimation model curve is created by regression analysis, from a plurality of data points indicating the amount of etching required for setting the IGSF density in the epitaxial growth layer of each reference substrate to 0.5 cm⁻² or lower, and the measured value of the scattered light intensity obtained in a case where P-polarized light and S-polarized light are made to enter each reference substrate, as illustrated in Fig. 8 (dashed lines in Fig. 8).

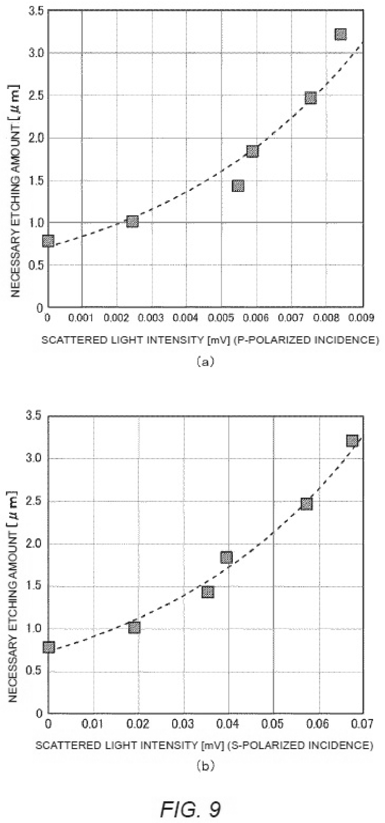

Alternatively, in step S61 according to the embodiment of the present invention, as illustrated in Fig. 9, a second data set may be created in which the amount of etching necessary for setting the BPD propagation rate in the epitaxial growth layer of each reference substrate to 0.1% or lower is associated with the measured value of the scattered light intensity obtained in a case where P-polarized light and S-polarized light are made to enter each reference substrate.

Further, in step S62 according to the embodiment of the present invention, an estimation model curve may be created by regression analysis, from a plurality of data points indicating the amount of etching required for setting the BPD propagation rate in the epitaxial growth layer of each reference substrate to 0.1% or lower, and the measured value of the scattered light intensity obtained in a case where P-polarized light and S-polarized light are made to enter each reference substrate, as illustrated in Fig. 9 (dashed lines in Fig. 9).

Note that, in a similar manner, an estimation model curve can be created by regression analysis, from a data set indicating the amount of etching necessary for setting the BPD density or some other killer defect density in the epitaxial growth layer of the reference substrate to a predetermined value or lower, and the measured value of the scattered light intensity obtained in a case where P-polarized light and S-polarized light are made to enter each reference substrate.

Further, as the measured value of the scattered light intensity, one or both of the measured values obtained in a case where P-polarized light or S-polarized light is made to enter each reference substrate may be used. However, S-polarized light has better measurement sensitivity in a shallow portion of a substrate, and therefore, it is preferable to use the measured value obtained when S-polarized light is made to enter in a case where one of the measured values obtained when P-polarized light or S-polarized light is made to enter each reference substrate is used as the measured value of scattered light intensity.

Using the estimation model created by the method as described above, it is possible to estimate the amount of processing necessary for the reference index of a substrate to satisfy the predetermined criterion, from the measured value of the scattered light intensity in the substrate.

### <<Method for Estimating Amount of Processing>>

### <Cleaning/Planarization Step S10>

A method for estimating an amount of processing according to the present invention may include the cleaning/planarization step S10 including the cleaning step S11 and/or the planarization step S12 described above, depending on the surface state of the semiconductor substrate 100 as the target substrate for which a necessary amount of processing is to be estimated.

### <Measurement Step S20>

The method for estimating an amount of processing according to the present invention includes a measurement step S20 of obtaining a measured value of the intensity of the scattered light L4 scattered on the surface 101 or in the subsurface damaged layer 102 present below the surface 101 of the semiconductor substrate 100 as the target substrate for which the necessary amount of processing is to be estimated. The specific method is the same as the first measurement step S20 described above, except that the semiconductor substrate 100 is the target substrate, and therefore, explanation thereof is omitted.

### <Estimation Step S70>

An estimation step S70 is a step of estimating an amount of processing necessary for the reference index in the target substrate to satisfy a predetermined criterion, from the measured value of the scattered light intensity in the target substrate as obtained in the above measurement step S20, on the basis of the estimation model created beforehand by the above method for creating an estimation model (S10 to S60).

In the estimation step S70 according to the embodiment of the present invention, an appropriate amount of etching to be performed on the target substrate is estimated from the measured value of the scattered light intensity obtained when P-polarized light and/or S-polarized light is made to enter the target substrate, to set the IGSF density in the epitaxial growth layer of the target substrate to 0.5 cm⁻² or lower or set the BPD propagation rate in the epitaxial growth layer of the target substrate to 0.1% or lower.

That is, the predetermined criterion according to the embodiment of the present invention is that "the IGSF density (reference index) in the epitaxial growth layer of the target substrate is 0.5 cm⁻² or lower", or "the BPD propagation rate (reference index) in the epitaxial growth layer of the target substrate is 0.1% or lower".

Any one of the predetermined criteria set in the analysis step S50 of the method for creating an estimation model can be selected.

For example, to set "the IGSF density in the epitaxial growth layer of the target substrate to 0.5 cm⁻² or lower", the amount of processing necessary for the target substrate can be estimated on the basis of an estimation model illustrated in Fig. 8.

In the present embodiment, with the estimation model illustrated in Fig. 8, in a case where the measured value of the scattered light intensity obtained when P-polarized light is made to enter the target substrate is about 0.002 mV, the amount of processing necessary for the target substrate can be estimated to be about 0.5 µm (Fig. 8(a)). Also, in a case where the measured value of the scattered light intensity obtained when S-polarized light is made to enter the target substrate is about 0.015 mV, the amount of processing necessary for the target substrate can be estimated to be about 0.5 µm (Fig. 8(b)).

Further, to set "the BPD propagation rate in the epitaxial growth layer of the target substrate to 0.1% or lower", for example, the amount of processing necessary for the target substrate can be estimated on the basis of an estimation model illustrated in Fig. 9.

In the present embodiment, with the estimation model illustrated in Fig. 9, in a case where the measured value of the scattered light intensity obtained when P-polarized light is made to enter the target substrate is about 0.002 mV, the amount of processing necessary for the target substrate can be estimated to be about 1.0 µm (Fig. 9(a)). Also, in a case where the measured value of the scattered light intensity obtained when S-polarized light is made to enter the target substrate is about 0.015 mV, the amount of processing necessary for the target substrate can be estimated to be about 1.0 µm (Fig. 9(b)).

In a case where the amount of processing is estimated using both P-polarized light and S-polarized light, the average value of the amounts of processing separately estimated using P-polarized light and S-polarized light may be used as the estimated value of the amount of processing.

For example, with the estimation model illustrated in Fig. 8, in a case where the mode value of the measured value of the scattered light intensity of P-polarized light in the target substrate is about 0.005 mV, the necessary amount of processing is estimated to be about 1.0 µm. Also, in a case where the mode value of the measured value of the scattered light intensity of S-polarized light in the target substrate is about 0.015 mV, the amount of processing necessary for the target substrate is estimated to be about 0.5 µm.

In this case, the final estimated value of the amount of processing may be estimated to be about 1.25 µm by calculating the average of the amount of processing (about 1.0 µm) required for the target substrate as estimated from the mode value of the measured value of the scattered light intensity of P-polarized light in the target substrate, and the amount of processing (about 0.5 µm) required for the target substrate as estimated from the mode value of the measured value of the scattered light intensity of S-polarized light in the target substrate.

In this manner, the amount of processing necessary for the target substrate can be estimated more accurately.

Further, in a case where the amount of processing is estimated using both P-polarized light and S-polarized light, the smaller one of the amounts of processing separately estimated using P-polarized light and S-polarized light may be used as the estimated value of the amount of processing.

For example, with the estimation model illustrated in Fig. 8, in a case where the mode value of the measured value of the scattered light intensity of P-polarized light in the target substrate is about 0.005 mV, the amount of processing necessary for the target substrate is estimated to be about 1.0 µm. Also, in a case where the mode value of the measured value of the scattered light intensity of S-polarized light in the target substrate is about 0.015 mV, the amount of processing necessary for the target substrate is estimated to be about 0.5 µm.

In this case, the final estimated value of the amount of processing may be estimated to be about 0.5 µm.

In this manner, the amount of processing necessary for the target substrate can be minimized, and the yield can be increased.

Further, in a case where the amount of processing is estimated using both P-polarized light and S-polarized light, the larger one of the amounts of processing separately estimated using P-polarized light and S-polarized light may be used as the estimated value of the amount of processing.

For example, with the estimation model illustrated in Fig. 8, in a case where the mode value of the measured value of the scattered light intensity of P-polarized light in the target substrate is about 0.005 mV, the amount of processing necessary for the target substrate is estimated to be about 1.0 µm. Also, in a case where the mode value of the measured value of the scattered light intensity of S-polarized light in the target substrate is about 0.015 mV, the amount of processing necessary for the target substrate is estimated to be about 0.5 µm.

In this case, the final estimated value of the amount of processing may be estimated to be about 1.0 µm.

In this manner, the amount of processing for the target substrate is made slightly excessive, so that the killer defects in the target substrate can be more reliably removed.

Note that, as described above with reference to Fig. 2, P-polarized light and S-polarized light have different suitable measurement depth ranges.

Therefore, in a case where the amount of processing is estimated using both P-polarized light and S-polarized light, when the amounts of processing separately estimated using the P-polarized light and the S-polarized light are different, any one of the values of the amounts of processing estimated using the P-polarized light and the S-polarized light may be preferentially used as the estimated value, regardless of the magnitudes of the values.

For example, if the required amount of etching is in a range of 10 µm, measurement with S-polarized light is suitable, and therefore, the amount of processing estimated using S-polarized light can be preferentially used as the estimated value, as in the present embodiment.

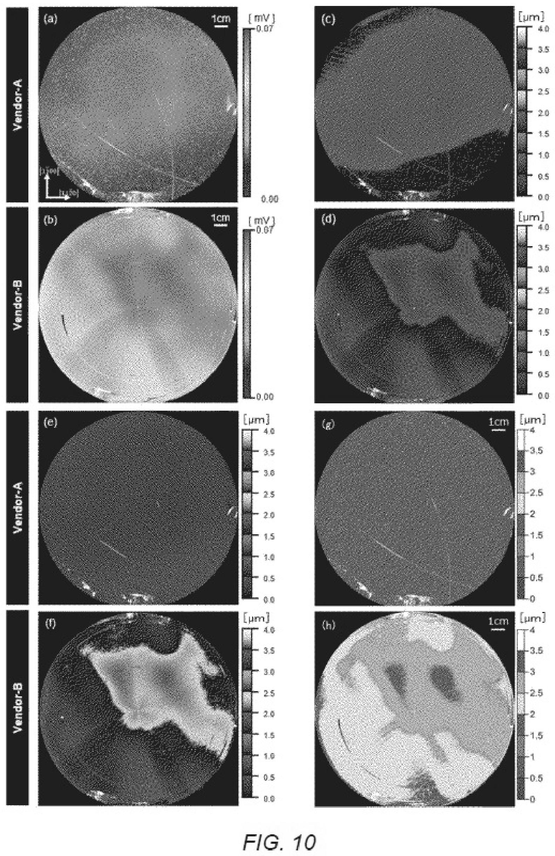

Fig. 10 shows, in different colors, scattered light intensities ((a), (b)) and the required processing amounts ((e) to (f)) on the entire surfaces of the respective target substrates manufactured by the respective manufacturers of Vender-A and Vender-B, according to the embodiment of the present invention.

As shown in Figs. 10(a) and 10(b), the measured scattered light intensities are not uniform even in a single substrate. That is, it is considered that the required amount of processing for satisfying the predetermined criterion is different for each portion of the substrate.

Therefore, as shown in Figs. 10(e) to 10(f), a distribution diagram of the amounts of processing estimated in the estimation step S70 can be created (a mapping step S71).

The mapping step S71 is a step of creating a distribution diagram of amounts of processing, on the basis of a plurality of thresholds for the necessary amounts of processing estimated for the respective portions of the substrate.

In this manner, it is possible to visually and stepwise identify the necessary amounts of processing estimated for the respective portions of the substrate.

For example, in the mapping step S71, for each target substrate, the distribution of the amounts of etching necessary for the target substrate to make the IGSF density in an epitaxial growth layer equal to or lower than a predetermined value, and the distribution of the amounts of etching necessary for the target substrate to make the BPD propagation rate in the epitaxial growth layer equal to or lower than a predetermined value can be displayed together with a scale bar divided for each unit thickness, within a predetermined range of the processable thickness of the target substrate.

Note that an amount of processing may be a process condition such as the time or the temperature for a certain process, and the upper and lower limit range and the division unit of the scale bar described above may be determined as appropriate depending on the process condition.

According to the present embodiment, for each target substrate manufactured by the respective manufacturers of Vender A and Vender B, the distribution (Figs. 10(c) and 10(d)) of the amount of etching required for the target substrate to set the IGSF density in the epitaxial growth layer to 0.5 cm⁻² or lower, and the distribution (Figs. 10(e) and 10(f)) of the amount of etching required for the target substrate to set the BPD propagation rate in the epitaxial growth layer to 0.1% or lower can be displayed together with a scale bar divided in units of 0.5 µm, in the range of 0 to 4 µm in the processable thickness of the target substrate.

Alternatively, it is also possible to set the predetermined criterion that the SF density (reference index) in the epitaxial growth layer is 0.1 cm⁻² or lower, and implement the above method for creating an estimation model and the above method for estimating an amount of processing (S10 to S70). In that case, the distribution (Figs. 10(g) and 10(h)) of the amount of etching necessary for the target substrate to set the IGSF density in the epitaxial growth layer to 0.1 cm⁻² or lower can be displayed together with a scale bar divided in units of 0.5 µm, in the range of 0 to 4 µm in the processable thickness of the target substrate.

### <<Method for Manufacturing Semiconductor Substrate>>

### <Manufacturing Step S80>

A manufacturing step S80 according to the present invention is a step of performing processing on a target substrate, on the basis of the appropriate amount of processing to be performed on the target substrate as estimated by the above-described method for estimating an amount of processing.

In the manufacturing step S80 according to the embodiment of the present invention, etching is performed on the target substrate, on the basis of the appropriate amount of etching to be performed on the target substrate to set the IGSF density in the epitaxial growth layer to 0.5 cm⁻² or lower or the BPD propagation rate in the epitaxial growth layer to 0.1% or lower, the appropriate amount of etching having been estimated in the estimation step S70.

For example, in the manufacturing step S80, the target substrate can be processed by the same amount as the appropriate amount of processing to be performed on the target substrate as estimated in the estimation step S70.

That is, in a case where the amount of etching necessary for the target substrate has been estimated to be about 1 µm on the basis of the estimation model illustrated in Fig. 7 in the estimation step S70, etching of about 1 µm can be performed on the target substrate in the manufacturing step S80.

Also, in the manufacturing step S80, the target substrate can be processed by a larger amount than the appropriate amount of processing to be performed on the target substrate, the appropriate amount having been estimated in the estimation step S70, for example.

That is, in a case where the amount of etching necessary for the target substrate has been estimated to be about 1 µm on the basis of the estimation model illustrated in Fig. 8 or 9 in the estimation step S70, etching of about 1.5 µm (the estimated value being +0.5 µm), about 2.0 µm (the estimated value being +1.0 µm), or about 2.5 µm (the estimated value being +1.5 µm), for example, can be performed on the target substrate in the manufacturing step S80.

In this manner, the killer defects in the target substrate can be more reliably removed.

Also, in the manufacturing step S80, the target substrate can be processed by a smaller amount than the appropriate amount of processing to be performed on the target substrate, the appropriate amount having been estimated in the estimation step S70, for example.

That is, in a case where the amount of etching necessary for the target substrate has been estimated to be about 1 µm on the basis of the estimation model illustrated in Fig. 8 or 9 in the estimation step S70, etching of about 1.5 µm (the estimated value being -0.5 µm), about 2.0 µm (the estimated value being -1.0 µm), or about 2.5 µm (the estimated value being -1.5 µm), for example, can be performed on the target substrate in the manufacturing step S80.

In this manner, the amount of processing for the target substrate can be minimized, and the yield can be increased.

### <<Planarity of Semiconductor Substrate>>

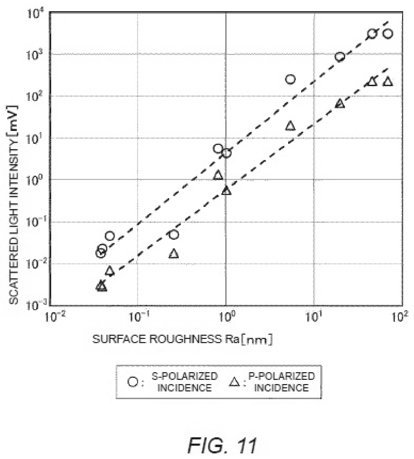

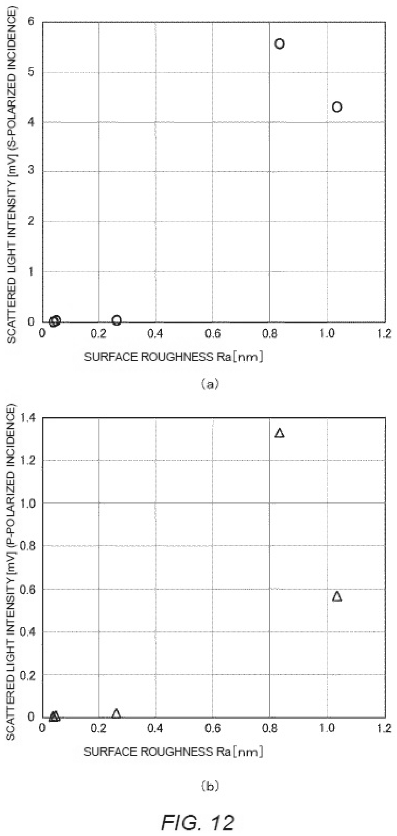

Referring now to Figs. 11 and 12, a preferred degree of planarity of the surface 101 of the semiconductor substrate 100 to be used as the reference substrate in the method for creating an estimation model and the target substrate in the method for estimating an amount of processing is described.

Here, the arithmetic average roughness (Ra) is defined as a value obtained by measuring the central portion and/or the peripheral portion of the semiconductor substrate 100 and a range having a length of about 10 µm with an atomic force microscope (AFM), but can also be defined by some other measurement region and measurement method.

Fig. 11 is a diagram illustrating the surface roughness Ra of a substrate, and the scattered light intensity obtained in a case where S-polarized light or P-polarized light is made to enter the substrate. As can be seen from Fig. 11, there is a positive correlation between the surface roughness Ra of the substrate and the scattered light intensity in a case where S-polarized light or P-polarized light is made to enter the substrate.

Fig. 12 is a diagram illustrating the relationship between the scattered light intensity measured using S-polarized light or P-polarized light and the roughness Ra of the surface 101, and corresponds to an enlarged view of part of the region in Fig. 11. Note that (a) and (b) correspond to the scattered light intensity obtained when S-polarized light was made to enter and the scattered light intensity obtained when P-polarized light was made to enter, respectively.

As shown in Fig. 12, in the range where the surface roughness Ra is greater than 0.8 nm, the scattered light intensity obtained when S-polarized light was made to enter is 4 mV, and the scattered light intensity obtained when P-polarized light was made to enter is a relatively great value exceeding 0.4 mV.

Considering the fact that the range of scattered light intensity in the second data sets shown in Figs. 8 and 9 is narrower than 0.1 mV in the case of S-polarized light incidence and is narrower than 0.01 mV in the case of P-polarized light incidence, and the above-described positive correlation between Ra and scattered light intensity, it is considered that the surface 101 of the semiconductor substrate 100 to be used as a reference substrate or a target substrate is preferably a surface having at least Ra of 0.8 nm or smaller, in order to reduce the influence of roughness on the scattered high intensity.

Therefore, the surface 101 of the semiconductor substrate 100 is preferably a surface having an arithmetic average roughness (Ra) of 0.8 nm or smaller, and more preferably, the surface 101 of the semiconductor substrate 100 is a surface having an arithmetic average roughness (Ra) of 0.5 nm or smaller.

Each of the configurations and functions described in the above embodiments is merely an example, and various modifications can be made to them on the basis of design requirements and the like.

### Reference Signs List

- 10: Light projecting system
- 11: Laser output unit
- 12: Wave plate
- 20: Light receiving system
- 21: Objective lens
- 22: Imaging lens
- 23: Beam splitter
- 24: Light receiving sensor
- 25: Slit
- 100: Semiconductor substrate
- 101: Surface
- 102: Subsurface damaged layer
- 103: Bulk layer
- L1: Laser light
- L2: Reflected light
- L3: Incident light
- L4: Scattered light
- N: Normal line
- θ: Incident angle
- φ: Measurement angle

## Claims

1. A method for estimating an appropriate amount of processing to be performed on a semiconductor substrate, the method comprising:
a measurement step of acquiring a measured value of an intensity of scattered light scattered in a target substrate by causing laser light to enter the target substrate; and
an estimation step of estimating an amount of processing necessary for a reference index in the target substrate to satisfy a predetermined criterion, from the measured value of the intensity of the scattered light in the target substrate, the measured value having been obtained in the measurement step, using an estimation model created on a basis of a data set in which a measured value of an intensity of scattered light scattered in a reference substrate measured by causing laser light to enter the reference substrate is associated with an amount of processing necessary for the reference index in the reference substrate to satisfy the predetermined criterion.

2. The estimation method according to claim 1, wherein the amount of processing includes an amount of non-contact processing.

3. The estimation method according to claim 2, wherein the amount of processing includes an amount of etching.

4. The estimation method according to claim 1, wherein the reference index includes an index measurable in a layer formed by performing an irreversible process on one of the reference substrate or the target substrate.

5. The estimation method according to claim 1, wherein the reference index includes an index measurable in a layer formed by performing an irreversible process on one of the reference substrate or the target substrate after non-contact processing.

6. The estimation method according to claim 1, wherein the reference index includes an index measurable in an epitaxial growth layer formed by epitaxially growing one of the reference substrate or the target substrate.

7. The estimation method according to claim 1, wherein the reference index includes an index measurable in an epitaxial growth layer formed by epitaxially growing one of the reference substrate or the target substrate after etching.

8. The estimation method according to claim 1, wherein the reference index includes a killer defect density in an epitaxial growth layer formed by epitaxially growing one of the reference substrate or the target substrate.

9. The estimation method according to claim 1, wherein the reference index includes an in-grown stacking fault (IGSF) density in an epitaxial growth layer formed by epitaxially growing one of the reference substrate or the target substrate.

10. The estimation method according to claim 1, wherein the reference index includes a basal plane dislocation (BPD) density in an epitaxial growth layer formed by epitaxially growing one of the reference substrate or the target substrate.

11. The estimation method according to claim 1, wherein the reference index includes a basal plane dislocation (BPD) propagation rate in an epitaxial growth layer formed by epitaxially growing one of the reference substrate or the target substrate.

12. The estimation method according to claim 1, further comprising a planarization step of planarizing a surface of the target substrate before the measurement step.

13. The estimation method according to claim 1, wherein the target substrate has an arithmetic average roughness Ra of less than 0.8 nm on a surface.

14. The estimation method according to claim 1, wherein the laser light is polarized light.

15. The estimation method according to claim 14, wherein the laser light is one of P-polarized light or S-polarized light.

16. A method for manufacturing a semiconductor substrate, comprising a step of performing processing on the target substrate, on a basis of the appropriate amount of processing to be performed on the target substrate, the appropriate amount of processing having been estimated by the estimation method according to any one of claims 1 to 15.

17. A method for creating an estimation model, comprising:
a first measurement step of acquiring a measured value of an intensity of scattered light scattered in each reference substrate of a plurality of reference substrates measured by causing laser light to enter each of the reference substrates;
a processing step of performing a process including processing of a different process amount on each of the reference substrates;
a second measurement step of measuring a reference index of each of the reference substrates;
an analysis step of creating a first data set in which the reference index of each of the reference substrates is associated with the amount of processing performed on each of the reference substrates, and estimating an amount of processing necessary for the reference index of each of the reference substrates to satisfy a predetermined criterion, on a basis of the first data set; and
an estimation model creating step of creating a second data set in which the amount of processing necessary for the reference index of each of the reference substrates estimated in the analysis step to satisfy the predetermined criterion is associated with the measured value of the intensity of the scattered light measured in the first measurement step, and creating an estimation model for estimating an appropriate amount of processing to be performed on a target substrate from a measured value of an intensity of scattered light in the target substrate, on a basis of the second data set.

18. The estimation method according to any one of claims 1 to 15, wherein the estimation model is an estimation model created using the method for creating an estimation model according to claim 17.
